# EUROPEAN PATENT APPLICATION

(11) **EP 4 538 607 A1**
(43) Date of publication of application: **16.04.2025**
(21) Application number: 22950653.0
(22) Date of filing: 14.07.2022
(51) Int. Cl.: F24F 7/08, F24F 13/30

(54) **INDIRECT EVAPORATIVE COOLING SYSTEM AND HEAT EXCHANGE ASSEMBLY**

(71) Applicant: Huawei Digital Power Technologies Co., Ltd., Shenzhen, Guangdong 518043 (CN)
(72) Inventor: SONG, Jinliang, Shenzhen, Guangdong 518043 (CN)
(74) Representative: Isarpatent
(86) International application number: PCT/CN2022/105797
(87) International publication number: WO 2024/011532

(57) **Abstract**

This application provides an indirect evaporation cooling system and a heat exchange component, which avoid the need of disposing ducts between the system and an equipment room for air circulation inside the equipment room and therefore occupy small space, thereby optimizing space of the equipment room. The system includes a box body, an indoor air channel, and an outdoor air channel. The indoor air channel communicates with an equipment room and may be used for air circulation inside the equipment room. The outdoor air channel communicates with an outside of the equipment room and may be used for air circulation outside the equipment room. A temperature of air outside the equipment room is lower than a temperature of air inside the equipment room. The indoor air channel and the outdoor air channel perform heat exchange, to reduce the temperature of the air inside the equipment room. An air intake vent and an air outlet vent of the indoor air channel are provided on a first side of the box body. The first side is configured to butt against a wall of the equipment room. An air intake vent of the outdoor air channel is provided on a side of the box body other than the first side, and an air outlet vent of the outdoor air channel is provided on a side of the box body other than the first side.

## Description

### TECHNICAL FIELD

This application relates to the field of mechanical design, and in particular, to an indirect evaporation cooling system and a heat exchange component.

### BACKGROUND

In an equipment room of a data center, an indirect evaporation cooling system is usually used to reduce an internal temperature of the data center. A most crucial part of the indirect evaporation cooling system is a heat exchange core, which is usually referred to as a heat exchanger. An air flow direction and a flow passage distribution structure inside the heat exchanger affect locations of an air return vent and an air exhaust vent of the data center.

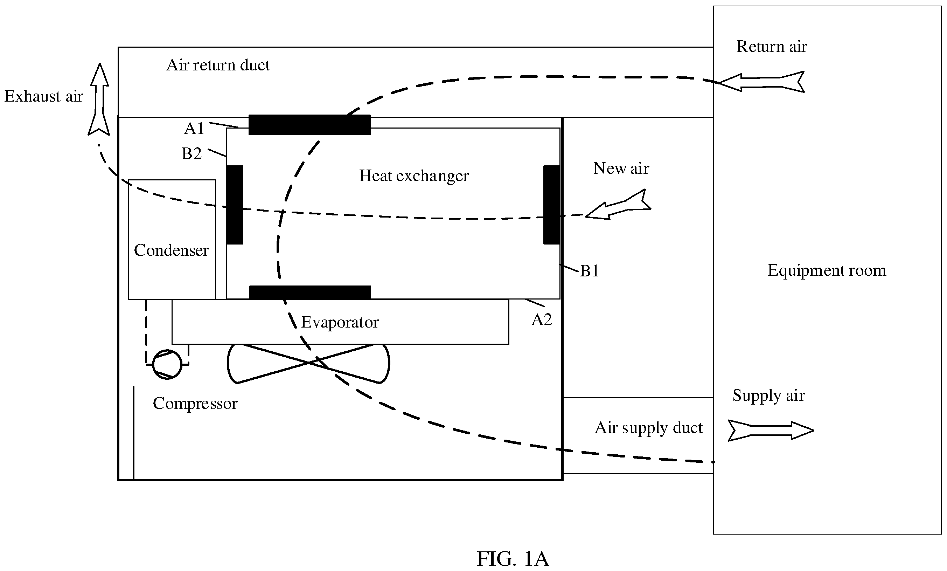

As shown in FIG. 1A, an existing indirect evaporation cooling system may include components such as a heat exchanger, an evaporator, a condenser, and a compressor. An air return vent is provided on a first surface (A1) of the heat exchanger, and communicates with an equipment room through an air return duct. On the heat exchanger, an air supply vent is provided on a second surface (A2) that is opposite to the first surface (A1), and communicates with the equipment room through an air supply duct. Air inside the equipment room enters the heat exchanger through the air return vent for heat exchange, and then flows out through the air supply vent. On the heat exchanger, a fresh air vent is provided on a third surface (B1) that adjoins the first surface (A1). An air exhaust vent is provided on a fourth surface (B2) that is opposite to the third surface (B1). Air outside the equipment room may enter the heat exchanger through the fresh air vent and flow out through the air exhaust vent.

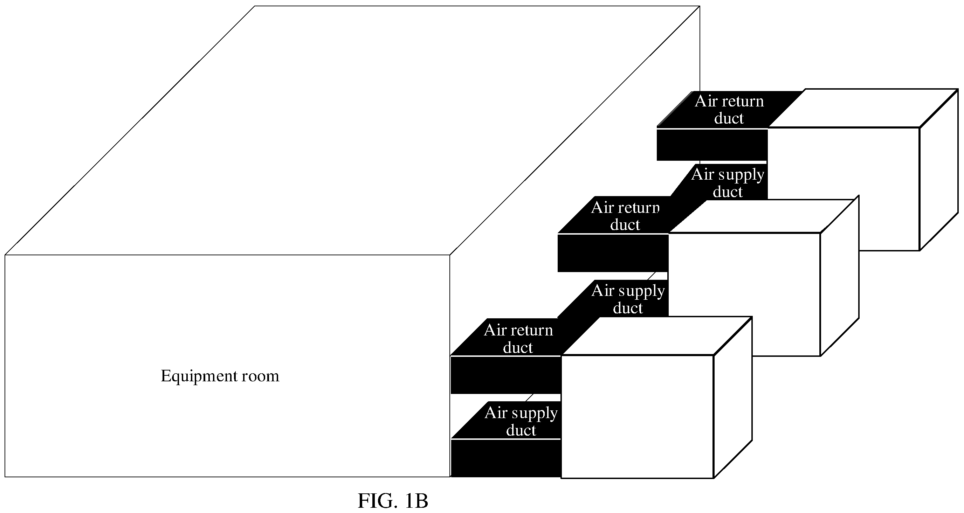

In an existing heat exchanger, an internal air flow passage of an equipment room and an external air flow passage of the equipment room are in a "cross" shape. Therefore, the heat exchanger is also referred to a cross-flow air-to-air heat exchanger. As shown in FIG. 1B, in an existing indirect evaporation cooling system, an air return duct and an air supply duct need to be additionally disposed, which need to occupy large space, thereby reducing available space of an equipment room of a data center.

### SUMMARY

This application provides an indirect evaporation cooling system and a heat exchange component, which avoid the need of disposing ducts between the system and an equipment room for air circulation inside the equipment room and therefore occupy small space, thereby optimizing space of the equipment room.

According to a first aspect, an embodiment of this application provides an indirect evaporation cooling system, which may be configured to dissipate heat for an equipment room. The system includes a box body, an indoor air channel, and an outdoor air channel. The indoor air channel communicates with the equipment room and may be used for air circulation inside the equipment room. The outdoor air channel communicates with an outside of the equipment room and may be used for air circulation outside the equipment room. A temperature of air outside the equipment room is lower than a temperature of air inside the equipment room. The indoor air channel and the outdoor air channel perform heat exchange, to reduce the temperature of the air inside the equipment room. An air intake vent and an air outlet vent of the indoor air channel are provided on a first side of the box body. The first side is configured to butt against a wall of the equipment room. An air intake vent of the outdoor air channel is provided on a side of the box body other than the first side, and an air outlet vent of the outdoor air channel is provided on a side of the box body other than the first side.

In this embodiment of this application, the indoor air channel of the indirect evaporation cooling system communicates with an inside of the equipment room. The indoor air channel of the indirect evaporation cooling system may refer to space, inside the system, for air circulation inside the equipment room. The indoor air channel may also be referred to as an indoor air path. The outdoor air channel communicates with an outside of the equipment room. The outdoor air channel may refer to space, inside the system, for air circulation outside the equipment room. The outdoor air channel may also be referred to as an outdoor air path. The air intake vent and the air outlet vent of the indoor air channel are both provided on the first side of the box body. The first side of the box body butts against a wall of the equipment room. In this way, air inside the equipment room may enter the indirect evaporation cooling system through the air intake vent of the indoor air channel and flows back to the equipment room through the air outlet vent of the indoor air channel. Both the air intake vent and the air exhaust vent of the outdoor air channel are not provided on the first side of the box body. In this design, ducts for air circulation inside the equipment room, for example, an air supply duct and an air return duct, do not need to be disposed at a position between the equipment room and the indirect evaporation cooling system. There is no need to reserve space for an outdoor air channel at the position between the equipment room and the indirect evaporation cooling system either. It can be seen that the indirect evaporation cooling system can directly butt against a wall of the equipment room, and therefore occupies small space, thereby improving available space of the equipment room.

The system includes a heat exchange component, and the heat exchange component has an enclosure, a first ventilation channel, and a second ventilation channel. An air inlet side and an air outlet side of the first ventilation channel are respectively provided on two adjoining surfaces of the enclosure. An air inlet side and an air outlet side of the second ventilation channel are respectively provided on two adjoining surfaces of the enclosure. The air inlet side of the first ventilation channel and the air inlet side of the second ventilation channel are respectively provided on two opposite surfaces of the enclosure, and the air outlet side of the first ventilation channel and the air outlet side of the second ventilation channel are respectively provided on two opposite surfaces of the enclosure. The first ventilation channel is disposed in the indoor air channel, and air inside the equipment room enters through the air inlet side of the first ventilation channel and is exhausted through the air outlet side of the first ventilation channel. The second ventilation channel is disposed in the outdoor air channel, and air outside the equipment room enters through the air inlet side of the second ventilation channel and is exhausted through the air outlet side of the second ventilation channel.

In this embodiment of this application, the first ventilation channel is in the indoor air channel, and the air inlet side and the air outlet side of the first ventilation channel are on two adjoining surfaces of the enclosure of the heat exchange component. The second ventilation channel is in the outdoor air channel, and the air inlet side and the air outlet side of the second ventilation channel are on two adjoining surfaces of the enclosure. A surface on which an air intake vent of the second ventilation channel is located is opposite to a surface on which an air intake vent of the first ventilation channel is located, and a surface on which an air outlet vent of the second ventilation channel is located is opposite to a surface on which an air outlet vent of the first ventilation channel is located. This design can increase space, inside the heat exchange component, for heat exchange and contact between air inside the equipment room and air outside the equipment room, thereby improving heat exchange efficiency.

In a possible design, the air intake vent of the outdoor air channel is provided on a second side of the box body, and the second side is opposite to the first side. The air outlet vent of the outdoor air channel is provided on a third side of the box body, and the third side adjoins the first side and is close to the air intake vent of the indoor air channel. In this design, both the air intake vent and the air outlet vent of the outdoor air channel are not located on the first side of the box body. Therefore, there is no need to reserve space for an outdoor air channel at the position between the equipment room and the indirect evaporation cooling system. The indirect evaporation cooling system can directly butt against a wall of the equipment room, and therefore occupies small space, thereby improving available space of the equipment room.

In a possible design, the system further includes a mechanical evaporation cooling component. The mechanical evaporation cooling component includes an evaporator and a condenser, and the evaporator communicates with the condenser. The evaporator is disposed in the indoor air channel, the evaporator is located between the heat exchange component and a fourth side of the box body, and the fourth side is opposite to the third side. The condenser is disposed between the heat exchange component and the third side. The condenser may be disposed at any position inside the box body of the indirect evaporation system. In this design, the evaporator in the mechanical evaporation cooling component may dissipate heat for air in the indoor air channel, so that the entire system has high heat dissipation efficiency.

In a possible design, a compressor is disposed between an outlet of the evaporator and an inlet of the condenser.

In a possible design, a first circulating pump is disposed between an inlet of the evaporator and an outlet of the condenser. Specifically, a fluorine pump may be selected as the first circulating pump, to reduce power consumption of the system.

In a possible design, the condenser avoids the indoor air channel and the outdoor air channel. For example, the condenser may avoid the air outlet side of the second ventilation channel. In other words, the condenser and a circulating path of air outside the equipment room do not interfere with each other. The condenser does not increase windage of the system, and circulation of the air outside the equipment room is not interfered with, so that well heat exchange with air inside the equipment room can be implemented.

In a possible design, a projection of the evaporator on the first side of the box body does not overlap with a projection of the air outlet vent of the indoor air channel on the first side of the box body. For example, the evaporator may avoid the air outlet vent of the indoor air channel. This reduces windage of the system and is conducive to heat exchange for air inside the equipment room.

In a possible design, the system further includes a liquid storage tank and a spray component. The spray component is disposed at a position of the air intake vent of the outdoor air channel, and the liquid storage tank communicates with the spray component to provide liquid for the sprinkling and spraying. In this design, the spray component can reduce a temperature of wind outside the equipment room that enters the system, thereby improving heat exchange efficiency of the system.

In a possible design, the system further includes a sprinkling component. The sprinkling component is disposed at a position of the air outlet vent of the outdoor air channel, and the liquid storage tank of the system communicates with the sprinkling component to provide liquid for the sprinkling component. In this design, the sprinkling component can reduce a temperature of wind outside the equipment room, thereby improving heat exchange efficiency of the system.

In a possible design, the system further includes a first fan component. The first fan component may be disposed in the indoor air channel, and is configured to drive air circulation inside the equipment room. For example, the first fan component may be disposed at the air outlet side of the first ventilation channel of the heat exchange component.

In a possible design, the system further includes a second fan component. The second fan component may be disposed at a position of the air outlet vent of the outdoor air channel, and is configured to drive air circulation outside the equipment room. For example, the second fan component may be disposed inside the box body, such as the air outlet side of the second ventilation channel. Alternatively, the second fan component may be disposed outside the box body.

According to a second aspect, an embodiment of this application provides a heat exchange component, which may include an enclosure and a first ventilation channel and a second ventilation channel that are provided inside the enclosure. Two openings of the first ventilation channel are respectively provided on a first surface of the enclosure and a second surface that adjoins the first surface. Two openings of the second ventilation channel are respectively provided on a third surface and a fourth surface of the enclosure. When the third surface is opposite to the first surface, the fourth surface is opposite to the second surface. This design can increase space, inside the heat exchange component, for heat exchange and contact between air inside an equipment room and air outside the equipment room, thereby improving heat exchange efficiency.

### BRIEF DESCRIPTION OF THE DRAWINGS

FIG. 1A and FIG. 1B are schematic diagrams of structures of existing indirect evaporation cooling systems;
FIG. 2A is a schematic diagram of a structure of an indirect evaporation cooling system according to an embodiment of this application;
FIG. 2B is a schematic diagram of a sectional structure of a plane in which A1-A1 in FIG. 2A is located;
FIG. 3A is an axonometric diagram of a heat exchange component in a first direction;
FIG. 3B is a schematic diagram of an air flow direction inside a first ventilation channel and a second ventilation channel on a plane in which A2-A2 in FIG. 3A is located;
FIG. 3C is an axonometric diagram of a heat exchange component in a second direction;
FIG. 4 is a schematic diagram of a structure of a first ventilation channel plate and a second ventilation channel plate of a heat exchange component;
FIG. 5A is a schematic diagram of a location of a heat exchange component in FIG. 2B;
FIG. 5B is a schematic diagram of a structure of another indirect evaporation cooling system according to an embodiment of this application;
FIG. 6 is a schematic diagram of a structure of still another indirect evaporation cooling system according to an embodiment of this application;
FIG. 7 is a schematic diagram of a structure of still another indirect evaporation cooling system according to an embodiment of this application;
FIG. 8 is a schematic diagram of a structure of still another indirect evaporation cooling system according to an embodiment of this application; and
FIG. 9 is a schematic diagram of an application scenario of an indirect evaporation cooling system.

### DESCRIPTION OF EMBODIMENTS

Terms used in the following embodiments are merely intended to describe particular embodiments, but are not intended to limit this application. As used in the specification and appended claims of this application, singular expressions "one", "a", "the", "the foregoing", "this", and "the one" are also intended to include expressions such as "one or more", unless the contrary is clearly indicated in its context.

Reference to "an embodiment", "some embodiments", or the like described in this specification indicates that one or more embodiments of this application include a specific feature, structure, or characteristic described with reference to the embodiments. Therefore, statements such as "in an embodiment", "in some embodiments", "in some other embodiments", and "in other embodiments" that appear at different places in this specification do not necessarily mean reference to a same embodiment, instead, they mean "one or more but not all of embodiments", unless otherwise specifically emphasized. The terms "include", "comprise", "have", and their variants all mean "include without being limited to", unless otherwise specifically emphasized.

An embodiment of this application provides an indirect evaporation cooling system that may be used to reduce a temperature of air inside an equipment room. The indirect evaporation cooling system may not require that an air return duct or an air supply duct for indoor air be additionally disposed. In addition, the indirect evaporation cooling system occupies small space, which is conducive to optimizing space of the equipment room. To make the objectives, technical solutions, and advantages of this application clearer, the following further describes this application in detail with reference to the accompanying drawings.

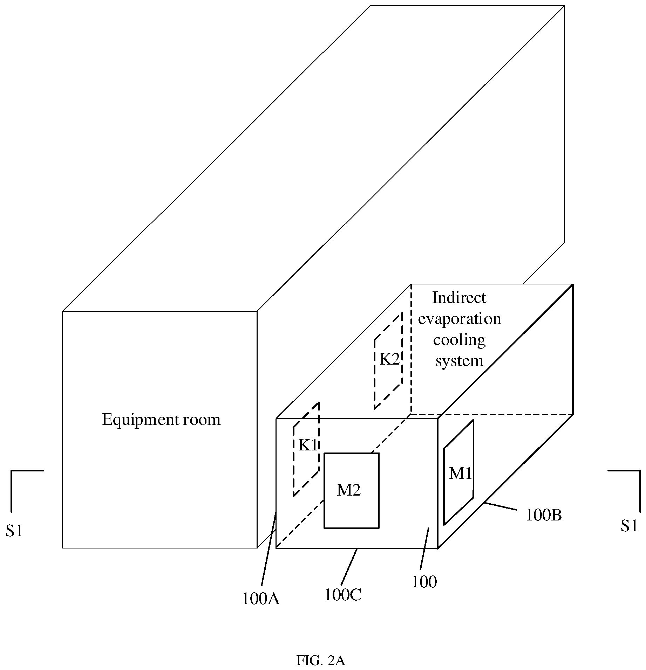

FIG. 2A is a schematic diagram of a 3D structure of an indirect evaporation cooling system. The indirect evaporation cooling system may be configured to reduce a temperature of air inside an equipment room. In some application scenarios, the equipment room may be an equipment room of a data center. The indirect evaporation cooling system may be configured to reduce a temperature of air with a high temperature inside the equipment room and then return the air back to the equipment room, thereby reducing the temperature of the air inside the equipment room. The indirect evaporation cooling system provided in this embodiment of this application may include a box body 100. A first side 100A of the box body 100 butts against a wall of the equipment room. An air intake vent K1 and an air exhaust vent K2 of an indoor air channel of the indirect evaporation cooling system may be provided on the first side 100A of the box body 100. Both an air intake vent M1 and an air exhaust vent M2 of an outdoor air channel of the indirect evaporation cooling system are not provided on the first side 100A of the box body 100. The air intake vent M1 and the air exhaust vent M2 of the outdoor air channel may be provided on a side of the box body 100 other than the first side 100A. In this design, the indirect evaporation cooling system directly butts against a wall of the equipment room. There is no need to dispose ducts between the system and the equipment room for air circulation inside the equipment room. Therefore, the indirect evaporation cooling system occupies small space, thereby optimizing space of the equipment room.

In some application scenarios, with reference to FIG. 2A again, the air intake vent M1 of the outdoor air channel may be provided on a second side 100B of the box body 100. The second side 100B is opposite to the first side 100A. Optionally, the air exhaust vent M2 of the outdoor air channel may be provided on a third side 100C of the box body 100. The third side surface 100C adjoins the first side surface 100A. The third side surface 100C is close to the air intake vent K1 of the indoor air channel and is away from the air outlet vent K2.

In this embodiment of this application, the indoor air channel of the indirect evaporation cooling system communicates with an inside of the equipment room. The indoor air channel of the indirect evaporation cooling system may refer to space, inside the system, for air circulation inside the equipment room. The indoor air channel may also be referred to as an indoor air path. The outdoor air channel communicates with an outside of the equipment room. The outdoor air channel may refer to space, inside the system, for air circulation outside the equipment room. The outdoor air channel may also be referred to as an outdoor air path.

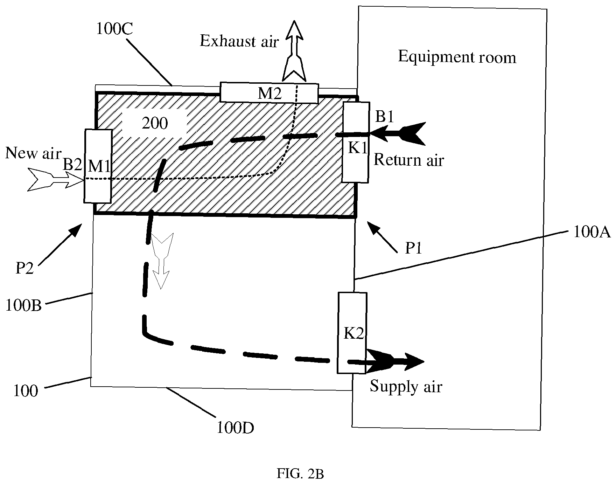

FIG. 2B is a schematic diagram of a sectional structure of a plane in which S1-S1 in FIG. 2A is located. In the indirect evaporation cooling system, the indoor air channel is used for air circulation inside the equipment room. For ease of description, in this application, a flow path B1 that is of air inside the equipment room and that is inside the indirect evaporation cooling system represents the indoor air channel, which is hereinafter denoted as an indoor air channel B1. Similarly, in the indirect evaporation cooling system, the outdoor air channel may also be referred to as a refresh air channel, and is used for air circulation outside the equipment room. For ease of description, in this application, a flow path B2 that is of air outside the equipment room and that is inside the indirect evaporation cooling system represents the outdoor air channel, which is hereinafter denoted as an outdoor air channel B2.

The indoor air channel B1 has an air intake vent K1 and an air outlet vent K2. Air inside the equipment room may enter the indoor air channel B1 through the air intake vent K1 and is exhausted to the equipment room through the air outlet vent K2. The outdoor air channel B2 is used for air circulation outside the equipment room. A temperature of air outside the equipment room is lower than that of air inside the equipment room. The outdoor air channel B2 and the indoor air channel B1 intersect. Air inside the equipment room and air outside the equipment room may perform heat exchange at a position of intersection between the outdoor air channel B2 and the indoor air channel B1. Specifically, the air outside the equipment room carries away heat of the air inside the equipment room, thereby cooling down and reducing a temperature of the air inside the equipment room.

In a possible scenario, the first side of the box body 100 has a plate-shaped structure. An opening that matches the air intake vent K1 and an opening that matches the air exhaust vent K2 are provided on a wall of the equipment room. A plate of the first side 100A of the box body 100 butts against the wall of the equipment room. The air intake vent K1 and the air exhaust vent K2 are provided on the plate of the first side 100A of the box body 100, which may respectively match the openings on the wall of the equipment room. In another possible scenario, the first side 100A of the box body 100 does not have a plate-shaped structure. In other words, a plate-shaped structure is not disposed on the first side 100A of the box body 100. The first side 100A of the box body 100 directly butts against a wall of the equipment room. Openings on the wall face both toward an inside of the box body 100, and are used as the air intake vent K1 and the air exhaust vent K2 of the indoor air channel B1.

The foregoing indirect evaporation cooling system may include a heat exchange component 200, such as a component shown in a shaded part in FIG. 2B. The heat exchange component 200 may be used for air circulation inside the equipment room, and may further be used for air circulation outside the equipment room. The air circulation inside the equipment room is isolated from the air circulation outside the equipment room, and only heat transfer is implemented. Specifically, when air inside the equipment room and air outside the equipment room both circulate inside the heat exchange component 200, heat of the air inside the equipment room may be transferred to the air outside the equipment room, and the air outside the equipment room carries away heat of the air inside the equipment room, thereby cooling down and reducing a temperature of the air inside the equipment room.

An embodiment of this application further provides a heat exchange component 200. The heat exchange component may have an enclosure, a first ventilation channel, and a second ventilation channel. The first ventilation channel is provided in an indoor air channel B1, and may be used for air circulation inside the equipment room. Air inside the equipment room enters through an air inlet side of the first ventilation channel and is exhausted through an air outlet side of the first ventilation channel. The second ventilation channel may be provided in an outdoor air channel B2, and may be used for air circulation outside the equipment room. Air outside the equipment room enters through an air inlet side of the second ventilation channel and is exhausted through an air outlet side of the second ventilation channel.

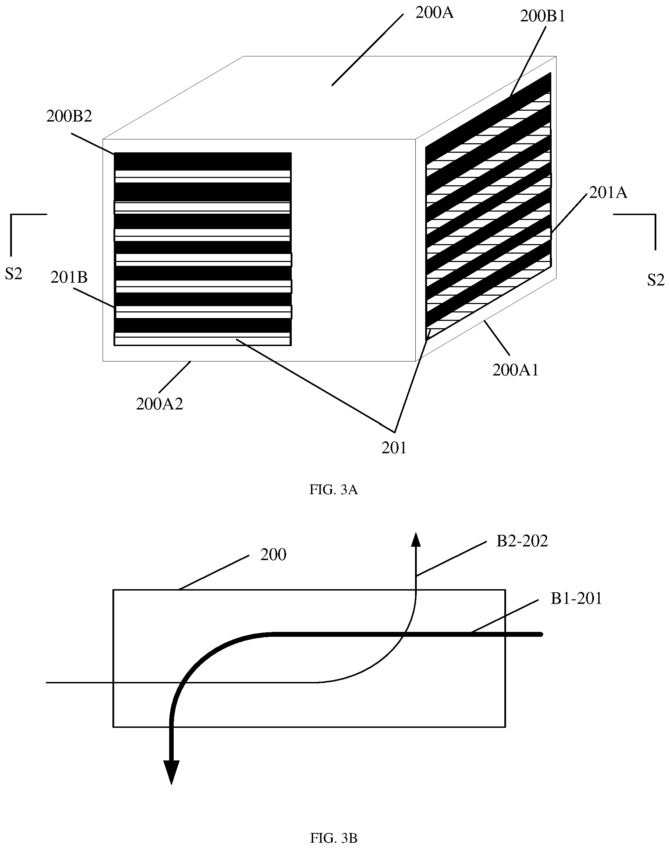

FIG. 3A is an example axonometric diagram of a heat exchange component 200 in a first direction. The first direction is a direction indicated by an arrow P1 in FIG. 2B. The heat exchange component 200 includes an enclosure 200A, a first ventilation channel 201, and a second ventilation channel (which is not shown in FIG. 3A). The heat exchange component 200 shown in FIG. 3A has a plurality of first ventilation channels 201 and a plurality of second ventilation channels. An air inlet side 201A and an air outlet side 201B of the first ventilation channel 201 are respectively provided on two adjoining surfaces of the enclosure 200A. For example, in the heat exchange component 200 shown in FIG. 3A, the air inlet side 201A of the first ventilation channel 201 is provided on a first surface 200A1 of the enclosure 200A. The first surface 200A1 of the enclosure 200A may have a first opening 200B1. The first opening 200B1 communicates with the air inlet side 201A of the first ventilation channel 201. Air may enter inside of the first ventilation channel 201 through the air inlet side 201A of the first ventilation channel 201.

The air outlet side 201B of the first ventilation channel 201 is provided on a second surface 200A2 of the enclosure 200A. The second surface 200A2 may have a second opening 200B2. The second opening B2 communicates with the air outlet side 201B of the first ventilation channel 201. Air inside the first ventilation channel 201 may flow out through the air outlet side 201B of the first ventilation channel 201.

FIG. 3B shows internal air flow directions of the first ventilation channel 201 and the second ventilation channel 202 on a plane in which S2-S2 in FIG. 3A is located. Both an internal air flow direction B1-201 of the first ventilation channel 201 and an internal air flow direction B2-202 of the second ventilation channel 202 assume an "L" shape. The heat exchange component 200 may also be referred to as an L-shaped countercurrent air-to-air heat exchanger.

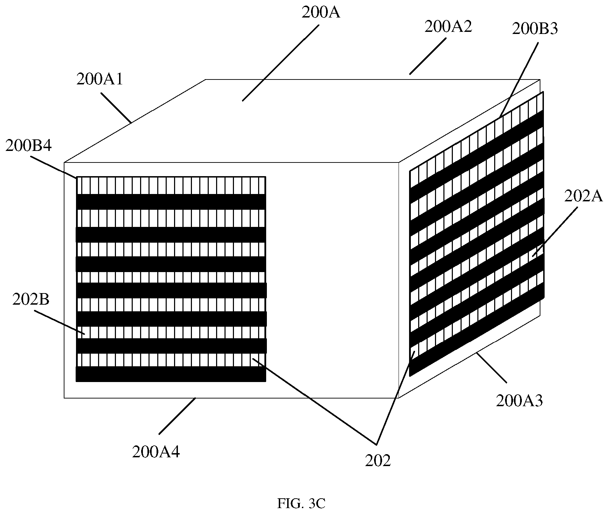

FIG. 3C is an axonometric diagram of the heat exchange component 200 shown in FIG. 3A in a second direction. The second direction is a direction indicated by an arrow P2 in FIG. 2B. As shown in FIG. 3B, an air inlet side 202A and an air outlet side 202B of the second ventilation channel 202 of the heat exchange component 200 are respectively provided on two adjoining surfaces of the enclosure 200A. For example, the air inlet side 202A of the second ventilation channel 202 is provided on a third surface 200A3 of the enclosure. The third surface 200A3 is opposite to the first surface 200A1. The third surface 200A3 of the enclosure 200A has a third opening 200B3. The third opening 200B3 communicates with the air inlet side 202A of the second ventilation channel 202. Air may flow out through the air outlet side 202B of the second ventilation channel 202.

The air outlet side 202B of the second ventilation channel 202 is provided on a fourth surface 200A4 of the enclosure. The fourth surface 200A4 is opposite to the second surface 200A2. The fourth surface 200A4 of the enclosure 200A has a fourth opening 200B4. The fourth opening 200B4 communicates with the air outlet side 202B of the second ventilation channel 200. Air inside the second ventilation channel 202 may flow out through the air outlet side 202B of the second ventilation channel 202.

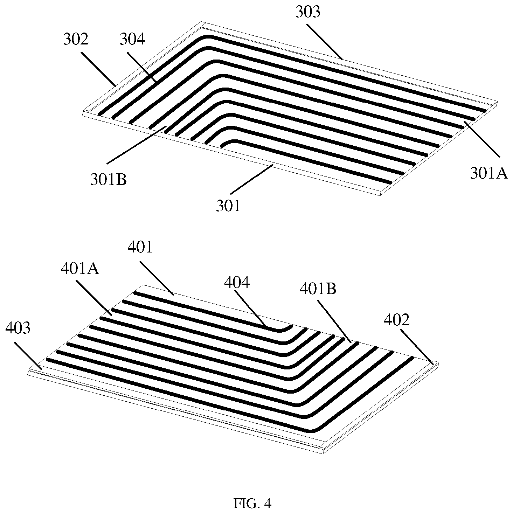

A core of the heat exchange component 200 may include a plurality of ventilation channel plates that are placed in a stacking manner. Structures of the ventilation channel plates may be the same. Two neighboring ventilation channel plates may separately form air paths in different directions. The heat exchange component 200 may include at least two ventilation channel plates. FIG. 4 is a schematic diagram of a structure of two neighboring ventilation channel plates in the core of the heat exchange component 200 shown in FIG. 3A and FIG. 3C. The two neighboring ventilation channel plates include a first ventilation channel plate and a second ventilation channel plate. The first ventilation channel plate is configured to form the first ventilation channel in the foregoing example, and the second ventilation channel plate is configured to form the second ventilation channel in the foregoing example.

As shown in FIG. 4 and FIG. 3A, the first ventilation channel plate may include a plate body 301. A first side 301A and a second side 301B of the plate body 301 may respectively serve as the air inlet side 201A and the air outlet side 201B of the first ventilation channel 201. The first side 301A and the second side 301B of the plate body 301 are two adjoining sides of the plate body 301. A first blocking part 302 is disposed at an opposite side of the first side 301A of the plate body 301, and a second blocking part 303 is disposed at an opposite side of the second side 301B. The first blocking part 302 and the second blocking part 303 are configured to change an air flow direction, so that air that enters through the first side 301A of the plate body 301 may then flow out through the second side 301B.

Optionally, at least one first separation part 304 may further be disposed on the plate body 301 of the first ventilation channel plate. This can reduce pressure of air circulation on the first blocking part 302 and the second blocking part 303. It should be noted that the first separation part 304 shown in FIG. 4 is intended for illustrative description, and does not serve to specifically limit a shape of the first separation part 304. In an actual application scenario, the first separation part 304 may alternatively use another shape.

As shown in FIG. 4 and FIG. 3C, the second ventilation channel plate may include a plate body 401. A first side 401A and a second side 401B of the plate body 401 may respectively serve as the air inlet side 202A and the air outlet side 202B of the second ventilation channel 202. The first side 401A and the second side 402B of the plate body 401 are two adjoining sides of the plate body 401. A third blocking part 402 is disposed at an opposite side of the first side 401A of the plate body 401, and a fourth blocking part 403 is disposed at an opposite side of the second side 401B. The third blocking part 402 and the fourth blocking part 403 are configured to change an air flow direction, so that air that enters through the first side 401A of the plate body 401 may then flow out through the second side 401B.

Optionally, at least one second separation part 404 may further be disposed on the plate body 401 of the second ventilation channel plate. This can reduce pressure of air circulation on the third blocking part 402 and the fourth blocking part 403. It should be noted that the second separation part 404 shown in FIG. 4 is intended for illustrative description, and does not serve to specifically limit a shape of the second separation part 404. In an actual application scenario, the second separation part 404 may alternatively use another shape.

In an indirect evaporation cooling system, the air inlet side 202A of the second ventilation channel 202 of the heat exchange component 200 may communicate with an air intake vent M1 of the outdoor air channel B2, and the air outlet side 202B of the second ventilation channel 202 may communicate with an air outlet vent M2 of the outdoor air channel B2. Air outside the equipment room may enter the second ventilation channel 202 of the heat exchange component through the air intake vent M1 of the outdoor air channel B2, and flows out through the air outlet vent M2 of the outdoor air channel B2 after passing through the second ventilation channel 202.

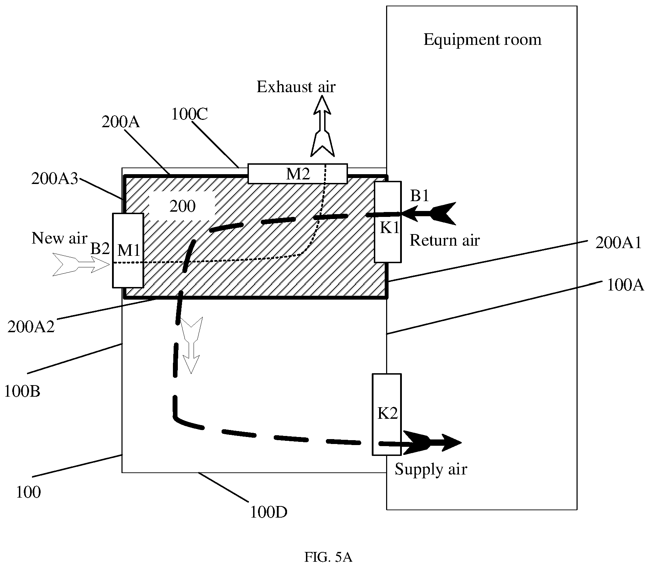

The third surface 200A3 of the enclosure 200A of the heat exchange component 200 may be parallel to an inner wall of a second side 100B of a box body 100. For example, FIG. 5A is a schematic diagram of a location of a heat exchange component 200 in the indirect evaporation cooling system shown in FIG. 2B. A third surface 200A3 of an enclosure 200A of the heat exchange component 200 may butt against an inner wall of the second side 100B of the box body 100.

A first surface 200A1 of the enclosure 200A of the heat exchange component 200 may butt against an inner wall of the first side 100A of the box body 100, or may butt against a wall of the equipment room. A second surface 200A2 of the enclosure 200A of the heat exchange component 200 and a fourth side 100D of the box body 100 may form a first channel. The first channel communicates with the air outlet vent K2 of the indoor air channel B1. Air inside the equipment room enters the first ventilation channel 201 of the heat exchange component through the air intake vent K1 of the indoor air channel B1, and after passing through the first ventilation channel 201, flows out through the air outlet vent K2 of the indoor air channel B1 through the first channel.

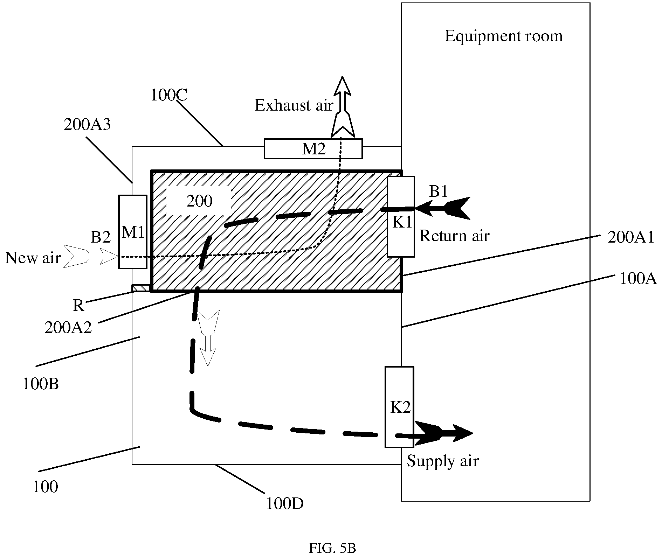

For another example, FIG. 5B is a schematic diagram of a location of another heat exchange component 200 in the indirect evaporation cooling system shown in FIG. 2B. A third surface 200A3 of an enclosure 200A of the heat exchange component 200 in FIG. 5B may be parallel to an inner wall of the second side 100B of the box body 100. A gap may exist between the third surface 200A3 of the enclosure 200A and the inner wall of the second side 100B of the box body 100.

In some application scenarios, with reference to FIG. 5B again, the indirect evaporation cooling system may include a baffle plate R. The baffle plate R is disposed between the third surface 200A3 of the enclosure 200A of the heat exchange component 200 and the inner wall of the second side 100B of the box body 100. The baffle plate R is configured to isolate air outside the equipment room and air inside the equipment room. The baffle plate, a second surface 200A2 of the enclosure 200A of the heat exchange component 200, and a fourth side 100D of the box body 100 may form a first channel. Air inside the equipment room may flow out through the air outlet vent K2 of the indoor air channel B1 after passing through the first channel.

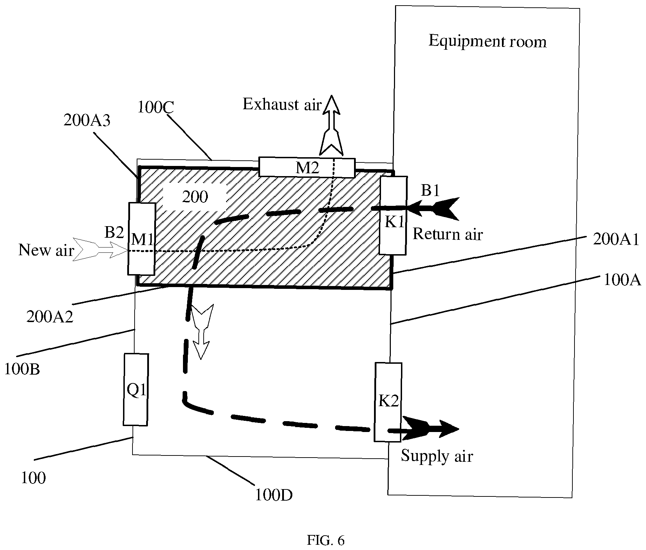

Based on the indirect evaporation cooling system provided in any of the foregoing examples, in the indirect evaporation cooling system, a hybrid loop air intake vent is provided on the second side of the box body. As shown in FIG. 6, a hybrid loop air intake vent Q1 is provided on a second side 100B of a box body 100. The hybrid loop air intake vent is on the second side 100B of the box body 100. For similarities of FIG. 6 with FIG. 2B, refer to related descriptions of FIG. 2B. Details are not described herein again. In this design, air outside the equipment room may enter a first channel through the hybrid loop air intake vent Q1. In the first channel, the air outside the equipment room is in direct contact with air inside the equipment room, and heat exchange is performed. Air that has undergone heat exchange flows out through the air outlet vent K2 of the indoor air channel B 1. Optionally, an air valve is disposed at a position of the hybrid loop air intake vent Q1, and is configured to adjust a volume of air outside the equipment room that enters the first channel.

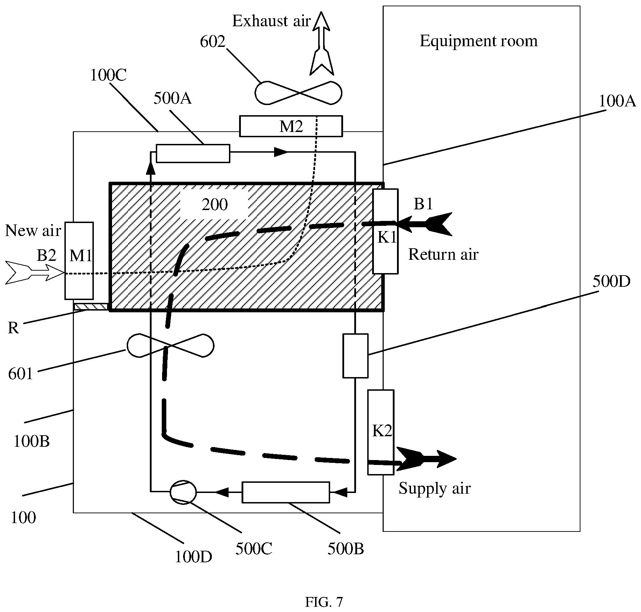

Based on the indirect evaporation cooling system provided in any of the foregoing examples, the indirect evaporation system may further include a mechanical evaporation cooling component. The mechanical evaporation cooling component may be configured to reduce a temperature of air inside the equipment room, for example, by absorbing heat of the air inside the equipment room through gas-liquid state conversion. For example, as shown in FIG. 7, a mechanical evaporation cooling component may include a condenser 500A and an evaporator 500B. The condenser 500A and the evaporator 500B communicate with each other. For similarities of FIG. 7 with FIG. 2B, refer to related descriptions of FIG. 5B. Details are not described herein again.

The evaporator 500B is disposed in the indoor air channel B2. The evaporator 500B may be located between the heat exchange component 200 and the fourth side 100D of the box body 100. In other words, the evaporator 500B may be disposed in the first channel and may absorb heat of air inside the equipment room. Optionally, the evaporator 500B is disposed in the first channel, and a projection of the evaporator 500B in a first direction (a direction pointing from the second side 100B of the box body 100 to the first side 100A of the box body 100) partially overlaps or completely overlaps with the air outlet vent K2 of the indoor air channel B1. Alternatively, the evaporator 500B may avoid the indoor air channel B1. For example, the evaporator 500B is disposed in the first channel, and a projection of the evaporator 500B on the first side 100A of the box body 100 does not overlap with a projection of the air outlet vent K2 on the first side 100A of the box body 100. This can reduce hindrance of the evaporator 500B to air circulation inside the equipment room.

Liquid refrigerant in the evaporator 500B absorbs heat of air inside the equipment room and then gasifies into gaseous refrigerant, which is transferred to the condenser 500A. The condenser 500A is configured to condense the gaseous refrigerant into liquid refrigerant, which is returned back to the evaporator 500B again and absorbs heat of air inside the equipment room through liquid-gas state conversion. The condenser 500A may be disposed between the heat exchange component 200 and the third side 100C of the box body 100. Optionally, a projection of the condenser 500A in a second direction (a direction pointing from the fourth side 100D of the box body 100 to the third side 100C of the box body 100) partially overlaps or completely overlaps with the air outlet vent M2 of the outdoor air channel B2. Alternatively, the condenser 500A may avoid the outdoor air channel B2, and a projection of the condenser 500A in a second direction does not overlap with the air outlet vent M2 of the outdoor air channel B2. This reduces resistance for air outside the equipment room to flow out of the second ventilation channel 202 of the heat exchange component 200.

Refer to FIG. 7 again. To implement gas and liquid circulation between the evaporator 500B and the condenser 500A, a compressor 500C is disposed on a path through which the evaporator 500B transports gaseous refrigerant to the condenser 500A. Specifically, the compressor 500C is disposed between an outlet of the evaporator 500B and an inlet of the condenser 500A. The compressor 500C sucks in gaseous refrigerant of the evaporator 500B, compresses the gaseous refrigerant to increase pressure of the gas, and then sends the gaseous refrigerant to the condenser 500A. The compressor 500C here may specifically be an air suspension compressor or a regular compressor, and can compress gaseous refrigerant in the mechanical evaporation cooling component. The compressor 500C may be an oil-free compressor, which can improve system reliability.

As shown in FIG. 7, the condenser 500A condenses gaseous refrigerant into liquid refrigerant, which is returned back to the evaporator 500B again. A first circulating pump 500D is disposed on a path through which the condenser 500A transports liquid refrigerant to the evaporator 500B. Specifically, the first circulating pump 500D is disposed between an inlet of the evaporator 500B and an outlet of the condenser 500A. A fluorine pump is selected and used as the first circulating pump 500D, which may specifically be a non-oil-lubricated liquid-floated fluorine pump or a regular fluorine pump. A fluorine pump being selected and used as the first circulating pump 500D can reduce power consumption of the entire system, further improving overall energy efficiency of the mechanical evaporation cooling component.

In a possible design, based on the indirect evaporation cooling system provided in any of the foregoing examples, with reference to FIG. 7 again, the indirect evaporation cooling system may further include a first fan component 601. The first fan component 601 is disposed in the indoor air channel and is configured to drive air circulation inside the equipment room. For example, the first fan component 601 may be disposed at a position of the air outlet side 201B of the first ventilation channel 201 of the heat exchange component 200. Alternatively, the first fan component 601 is disposed between the air outlet side 201B of the first ventilation channel 201 and the fourth side 100D of the box body 100. Optionally, the indirect evaporation cooling system may further include a second fan component 602, which is configured to drive air circulation outside the equipment room. The second fan component 602 may be disposed at a position of the air outlet vent M2 of the outdoor air channel.

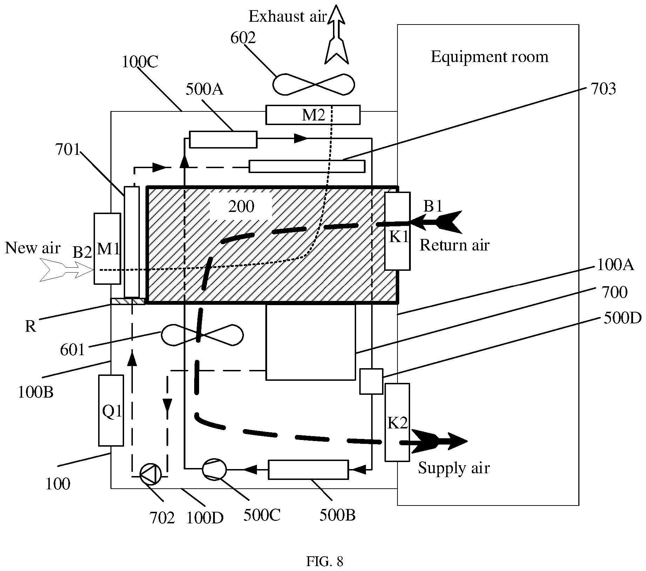

In a possible design, based on the indirect evaporation cooling system provided in any of the foregoing examples, the indirect evaporation cooling system may further include a liquid storage tank, which may store liquid. In an embodiment, the liquid storage tank may be disposed between the heat exchange component and the third side of the box body. Optionally, the liquid storage tank may avoid indoor and outdoor loops, to reduce resistance to air circulation outside the equipment room. In another embodiment, as shown in FIG. 8, a liquid storage tank 700 may be disposed between the heat exchange component 200 and the fourth side 100D of the box body 100. Optionally, the liquid storage tank 700 may avoid the indoor air channel, to reduce resistance to air circulation inside the equipment room. For similarities of FIG. 8 with FIG. 2B, refer to related descriptions of FIG. 7. Details are not described herein again.

Refer to FIG. 8 again. The indirect evaporation cooling system may further include a spray component 701. The spray component 701 is specifically disposed at a position of the air intake vent M1 of the outdoor air channel B2. For example, as shown in FIG. 8, the spray component 701 is located between the position of the air intake vent M1 of the outdoor air channel B2 and the air inlet side 202A of the second ventilation channel 202 of the heat exchange component 200. A water pump 702 is disposed between a liquid inlet of the sprinkling component 701 and a liquid outlet of the liquid storage tank 700. The spray component 701 communicates with the liquid storage tank 700. The liquid storage tank 700 in the indirect evaporation cooling system may supply liquid for the spray component 701. The spray component 701 may reduce, through mist spraying, a temperature of air outside the equipment room that enters the second ventilation channel 202. This is conducive to improving an effect of heat exchange between the air outside the equipment room and air inside the equipment room. Optionally, the spray component 700 may include a spray sprinkling element or a wet film sprinkling element.

Optionally, the indirect evaporation cooling system provided in this embodiment of this application is further provided with a sprinkling component 703. The sprinkling component 703 is specifically disposed at a position of the air exhaust vent M2 of the outdoor air channel B2, for example, the air outlet side 202B of the second ventilation channel 202. The sprinkling component 703 communicates with the liquid storage tank 700. The liquid storage tank 700 may supply liquid for the sprinkling component 703. The sprinkling component 703 may reduce, through sprinkling, a temperature of air in the second ventilation channel 202. This is conducive to improving an effect of heat exchange between air outside the equipment room and air inside the equipment room. Optionally, the sprinkling component 703 may include a water sprinkling element.

Based on the indirect evaporation cooling system shown in FIG. 8, the following describes a working principle of the indirect evaporation cooling system provided in embodiments of this application. In actual application, the indirect evaporation cooling system has a plurality of working modes. A working mode of the indirect evaporation cooling system may be properly selected based on a temperature of an actual application scenario. The following describes the working modes of the indirect evaporation cooling system. An operating temperature range corresponding to each working mode is used as an example for reference, and does not specifically limit an operating temperature range corresponding to the working mode.

The indirect evaporation cooling system may have an air-to-air heat exchange mode. In the air-to-air heat exchange mode, the outdoor air channel is started to extract air outside the equipment room to the heat exchange component 200. The air outside the equipment room circulates inside the second ventilation channel 202 of the heat exchange component 200. The air outside the equipment room in the second ventilation channel 202 and air inside the equipment room in the first ventilation channel 201 undergo air-to-air heat exchange in the heat exchange component 200, to cool down and reduce a temperature of the air inside the equipment room. In the air-to-air heat exchange mode, it is equivalent that the air inside the equipment room has passed through both the heat exchange component 200 and a mechanical cooling component, but heat exchange and temperature reduction occur only at the heat exchange component 200. Optionally, when an outdoor temperature (which is equivalent to a temperature of the air outside the equipment room) is lower than a first temperature, the indirect evaporation cooling system may be set to the air-to-air heat exchange mode. For example, the first temperature may be 15°C.

The indirect evaporation cooling system may have a complete fresh air natural cooling mode. In the complete fresh air natural cooling mode, a hybrid loop air intake vent is enabled, and air outside the equipment room enters the first channel (of the heat exchange component 200) through the hybrid loop air intake vent. In the first channel, the air outside the equipment room is directly mixed with air inside the equipment room, to cool down and reduce a temperature of the air inside the equipment room. In the complete fresh air natural cooling mode, the air inside the equipment room enters the first channel through the first ventilation channel of the heat exchange component, and temperature reduction occurs only in the first channel. Optionally, when an indoor temperature is greater than a first temperature and less than a second temperature, the indirect evaporation cooling system may be set to the complete fresh air natural cooling mode. For example, the first temperature may be 15°C, and the second temperature may be 27°C.

The indirect evaporation cooling system may have a first hybrid mode. The first hybrid mode is a composite air-to-air heat exchange + mechanical refrigeration and supplementary cooling mode. In the first hybrid mode, the outdoor air channel is started to extract air outside the equipment room to the heat exchange component 200. The air outside the equipment room circulates inside the second ventilation channel 202 of the heat exchange component 200. The air outside the equipment room in the second ventilation channel 202 and air inside the equipment room in the first ventilation channel 201 undergo air-to-air heat exchange in the heat exchange component 200, to cool down and reduce a temperature of the air inside the equipment room. In addition, the evaporator 500B, the condenser 500A, and the compressor 500C are started. The compressor 500C works, to transport refrigerant gasified by the evaporator 500B to an input port of the condenser 500A. The evaporator 500B absorbs heat of the air inside the equipment room to gasify the refrigerant, which is transferred to the condenser 500A for heat discharge and condensation into liquid, thereby cooling down and reducing a temperature of the air inside the equipment room. In the first hybrid mode, it is equivalent that the air inside the equipment room of the equipment room has passed through both the heat exchange component 200 and the evaporator 500B. In addition, heat exchange and temperature reduction occur at the heat exchange component 200, and heat discharge and temperature reduction occur at the evaporator 500B. Optionally, when an indoor temperature is greater than a first temperature, the indirect evaporation cooling system may be set to the first hybrid mode. For example, the first temperature may be 15°C.

The indirect evaporation cooling system may have a second hybrid mode. The second hybrid mode is a composite air-to-air heat exchange + fluorine pump mode. In the second hybrid mode, the outdoor air channel is started to extract air outside the equipment room to the heat exchange component 200. The air outside the equipment room circulates inside the second ventilation channel 202 of the heat exchange component 200. The air outside the equipment room in the second ventilation channel 202 and air inside the equipment room in the first ventilation channel 201 undergo air-to-air heat exchange in the heat exchange component 200, to cool down and reduce a temperature of the air inside the equipment room. In addition, the evaporator 500B, the condenser 500A, and the fluorine pump are started. When the fluorine pump works, liquid refrigerant output by the condenser 500A may be sent back to an input port of the evaporator 500B. The evaporator 500B absorbs heat of the air inside the equipment room to gasify the refrigerant, which is transferred to the condenser 500A for heat discharge and condensation into liquid, thereby cooling down and reducing a temperature of the air inside the equipment room. In the second hybrid mode, it is equivalent that the air inside the equipment room of the equipment room has passed through both the heat exchange component 200 and the evaporator 500B. In addition, heat exchange and temperature reduction occur at the heat exchange component 200, and heat discharge and temperature reduction occur at the evaporator 500B. Optionally, when an indoor temperature is greater than a first temperature and less than a second temperature, the indirect evaporation cooling system may be set to the second hybrid mode. For example, the first temperature may be 5°C, and the second temperature may be 20°C. Compared to the first hybrid mode, the second hybrid mode has less system power consumption.

The indirect evaporation cooling system may have a third hybrid mode. The third hybrid mode is a composite air-to-air heat exchange + mist spraying mode. In the third hybrid mode, the outdoor air channel is started to extract air outside the equipment room to the heat exchange component 200. The air outside the equipment room circulates inside the second ventilation channel 202 of the heat exchange component 200. The air outside the equipment room in the second ventilation channel 202 and air inside the equipment room in the first ventilation channel 201 undergo air-to-air heat exchange in the heat exchange component 200, to cool down and reduce a temperature of the air inside the equipment room. In addition, the spray component is started. The spray component may spray mist on outdoor air that is extracted to the heat exchange component, to reduce a temperature of the air outside the equipment room that enters the second ventilation channel of the heat exchange component. This can improve efficiency of heat exchange between the air outside the equipment room and the air inside the equipment room in the heat exchange component. Optionally, when an indoor temperature is greater than a first temperature and less than a second temperature, the indirect evaporation cooling system may be set to the third hybrid mode. For example, the first temperature may be 15°C, and the second temperature may be 18°C.

The indirect evaporation cooling system may have a fourth hybrid mode. The fourth hybrid mode is a composite air-to-air heat exchange + sprinkling mode. In the fourth hybrid mode, the outdoor air channel is started to extract air outside the equipment room to the heat exchange component 200. The air outside the equipment room circulates inside the second ventilation channel 202 of the heat exchange component 200. The air outside the equipment room in the second ventilation channel 202 and air inside the equipment room in the first ventilation channel 201 undergo air-to-air heat exchange in the heat exchange component 200, to cool down and reduce a temperature of the air inside the equipment room. In addition, the sprinkling component is started. The sprinkling component may perform sprinkling on outdoor air in the heat exchange component, to reduce a temperature of the air outside the equipment room that is in the second ventilation channel of the heat exchange component. This can improve efficiency of heat exchange between the air outside the equipment room and the air inside the equipment room in the heat exchange component. Optionally, when an indoor temperature is greater than a first temperature, the indirect evaporation cooling system may be set to the fourth hybrid mode. For example, the first temperature may be 18°C.

The indirect evaporation cooling system may have a fifth hybrid mode. The fifth hybrid mode is a composite air-to-air heat exchange + sprinkling + mechanical refrigeration and supplementary cooling mode. In the fifth hybrid mode, the outdoor air channel is started to extract air outside the equipment room to the heat exchange component 200. The air outside the equipment room circulates inside the second ventilation channel 202 of the heat exchange component 200. The air outside the equipment room in the second ventilation channel 202 and air inside the equipment room in the first ventilation channel 201 undergo air-to-air heat exchange in the heat exchange component 200, to cool down and reduce a temperature of the air inside the equipment room. In addition, the sprinkling component is started. The sprinkling component may perform sprinkling on outdoor air in the heat exchange component, to reduce a temperature of the air outside the equipment room that is in the second ventilation channel of the heat exchange component. This can improve efficiency of heat exchange between the air outside the equipment room and the air inside the equipment room in the heat exchange component. In addition, the evaporator 500B, the condenser 500A, and the compressor 500C are started. The compressor 500C works, to transport refrigerant gasified by the evaporator 500B to an input port of the condenser 500A. The evaporator 500B absorbs heat of the air inside the equipment room to gasify the refrigerant, which is transferred to the condenser 500A for heat discharge and condensation into liquid, thereby cooling down and reducing a temperature of the air inside the equipment room. In the fifth hybrid mode, it is equivalent that the air inside the equipment room of the equipment room has passed through both the heat exchange component 200 and the evaporator 500B. In addition, heat exchange and temperature reduction occur at the heat exchange component 200, and heat discharge and temperature reduction occur at the evaporator 500B. Optionally, when an indoor temperature is greater than a first temperature and a wet-bulb temperature is greater than a target wet-bulb temperature, the indirect evaporation cooling system may be set to the fifth hybrid mode. For example, the first temperature may be 22°C, and the target wet-bulb temperature may be 19°C.

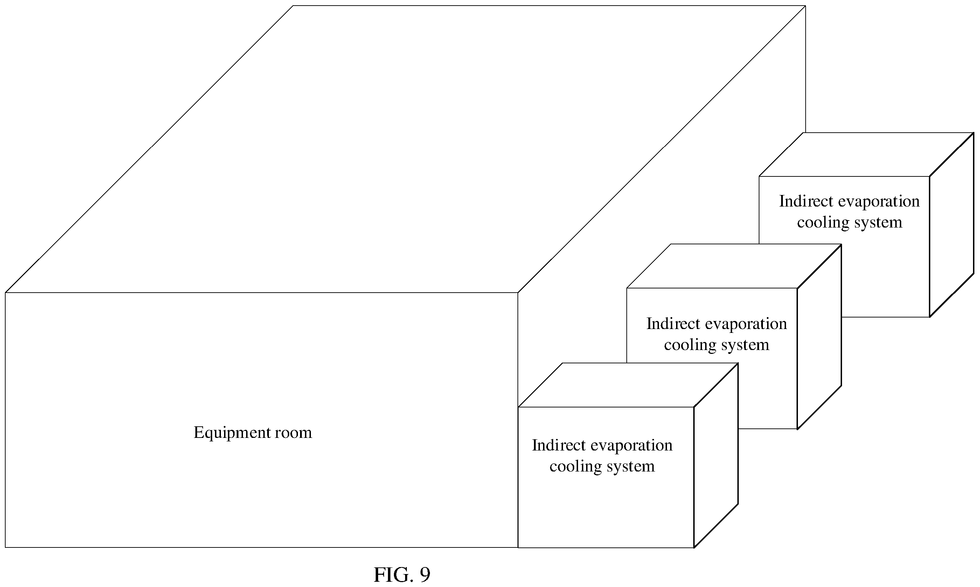

In a possible application scenario, FIG. 9 is a schematic diagram of an application scenario of an indirect evaporation cooling system. As shown in FIG. 9, a plurality of indirect evaporation cooling systems may be configured to adjust a temperature of an equipment room. Each indirect evaporation cooling system may use a structure of any indirect evaporation cooling system provided in embodiments of this application. For example, each indirect evaporation cooling system may work independently. For another example, the plurality of indirect evaporation cooling systems may work in coordination. For still another example, each indirect evaporation cooling system may work independently, and may also work with another indirect evaporation cooling system.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An indirect evaporation cooling system, wherein the system comprises a box body, an indoor air channel, and an outdoor air channel; the indoor air channel communicates with an equipment room and is used for air circulation inside the equipment room; the outdoor air channel communicates with an outside of the equipment room and is used for air circulation outside the equipment room; and a temperature of air outside the equipment room is lower than a temperature of air inside the equipment room, and the indoor air channel and the outdoor air channel perform heat exchange; and
an air intake vent and an air outlet vent of the indoor air channel are provided on a first side of the box body; the first side is configured to butt against a wall of the equipment room; and an air intake vent of the outdoor air channel is provided on a side of the box body other than the first side, and an air outlet vent of the outdoor air channel is provided on a side of the box body other than the first side.

2. The system according to claim 1, wherein the system comprises a heat exchange component, and the heat exchange component has an enclosure, a first ventilation channel, and a second ventilation channel, wherein
an air inlet side and an air outlet side of the first ventilation channel are respectively provided on two adjoining surfaces of the enclosure, an air inlet side and an air outlet side of the second ventilation channel are respectively provided on two adjoining surfaces of the enclosure, the air inlet side of the first ventilation channel and the air inlet side of the second ventilation channel are respectively provided on two opposite surfaces of the enclosure, and the air outlet side of the first ventilation channel and the air outlet side of the second ventilation channel are respectively provided on two opposite surfaces of the enclosure;
the first ventilation channel is disposed in the indoor air channel, and air inside the equipment room enters through the air inlet side of the first ventilation channel and is exhausted through the air outlet side of the first ventilation channel; and
the second ventilation channel is disposed in the outdoor air channel, and air outside the equipment room enters through the air inlet side of the second ventilation channel and is exhausted through the air outlet side of the second ventilation channel.

3. The system according to claim 2, wherein the air intake vent of the outdoor air channel is provided on a second side of the box body, the second side is opposite to the first side, the air outlet vent of the outdoor air channel is provided on a third side of the box body, and the third side adjoins the first side and is close to the air intake vent of the indoor air channel.

4. The system according to claim 2, wherein the system comprises a mechanical evaporation cooling component, the mechanical evaporation cooling component comprises an evaporator and a condenser, and the evaporator communicates with the condenser;
the evaporator is disposed in the indoor air channel, the evaporator is located between the heat exchange component and a fourth side of the box body, and the fourth side is opposite to the third side; and
the condenser is disposed between the heat exchange component and the third side.

5. The system according to claim 4, wherein a compressor is disposed between an outlet of the evaporator and an inlet of the condenser.

6. The system according to claim 4 or 5, wherein a first circulating pump is disposed between an inlet of the evaporator and an outlet of the condenser.

7. The system according to claim 6, wherein the first circulating pump is a fluorine pump.

8. The system according to any one of claims 4 to 7, wherein the condenser avoids the indoor air channel and the outdoor air channel.

9. The system according to any one of claims 4 to 8, wherein a projection of the evaporator on the first side of the box body does not overlap with a projection of the air outlet vent of the indoor air channel on the first side of the box body.

10. The system according to any one of claims 1 to 9, wherein the system comprises a liquid storage tank and a spray component, the spray component is disposed at a position of the air intake vent of the outdoor air channel, and the liquid storage tank communicates with the spray component to provide liquid for the sprinkling and spraying.

11. The system according to any one of claims 2 to 10, wherein the system further comprises a sprinkling component, the sprinkling component is disposed at a position of the air outlet vent of the outdoor air channel, and the liquid storage tank of the system communicates with the sprinkling component to provide liquid for the sprinkling component.

12. The system according to any one of claims 2 to 11, wherein the system further comprises a first fan component; and
the first fan component is disposed in the indoor air channel, and is configured to drive air circulation inside the equipment room.

13. The system according to any one of claims 2 to 12, wherein the system further comprises a second fan component; and
the second fan component is disposed at a position of the air outlet vent of the outdoor air channel, and is configured to drive air circulation outside the equipment room.

14. A heat exchange component, comprising an enclosure and a first ventilation channel and a second ventilation channel that are provided inside the enclosure, wherein
two openings of the first ventilation channel are respectively provided on a first surface of the enclosure and a second surface that adjoins the first surface; and
two openings of the second ventilation channel are respectively provided on a third surface and a fourth surface of the enclosure, and when the third surface is opposite to the first surface, the fourth surface is opposite to the second surface.
